# EUROPÄISCHE PATENTSCHRIFT

(11) **EP 1 678 767 B1**
(45) Veröffentlichungstag und Bekanntmachung des Hinweises auf die Patenterteilung: **06.04.2011**
(21) Anmeldenummer: 04791185.4
(22) Anmeldetag: 08.10.2004
(51) Int. Cl.: H01L 29/786, H01L 21/336, H01L 29/788

(54) **VERFAHREN ZUM HERSTELLEN EINES VERTIKALEN FELDEFFEKTTRANSISTORS**
METHOD FOR PRODUCING A VERTICAL FIELD EFFECT TRANSISTOR
PROCEDE DE PRODUCTION D'UN TRANSISTOR A EFFET DE CHAMP VERTICAL

(30) Priorität: 30.10.2003 DE 10350751
(43) Veröffentlichungstag der Anmeldung: 12.07.2006
(60) Teilanmeldung: 10188385.8
(73) Patentinhaber: Infineon Technologies AG, 85579 Neubiberg (DE)
(72) Erfinder: TEWS, Helmut, 81549 München (DE)
(74) Vertreter: Karl, Frank
(86) Internationale Anmeldenummer: PCT/EP2004/052485
(87) Internationale Veröffentlichungsnummer: WO 2005/043629

(56) Entgegenhaltungen:
- US-A1- 2002 140 032
- US-A1- 2002 195 649
- US-B1- 6 197 641
- US-B1- 6 303 425
- US-B1- 6 433 382

## Beschreibung

Die Erfindung betrifft ein Verfahren zum Herstellen eines vertikalen Feldeffekttransistors gemäß den Ansprüchen 1-11 ohne Beschränkung durch die Reihenfolge, in der die Schritte genannt sind.

Das Feldeffektprinzip besteht darin, den Stromfluss in dem Kanal über das Potential an der Steuerelektrode zu beeinflussen. Die Steuerelektrode wird auch als Gate bezeichnet. Die Feldeffekttransistoren für Logikschaltungen sollen eine kurze Gatelänge, ein dünnes Gatedielektrikum und gleichzeitig einen großen Einschaltstrom haben. Die Betriebsspannung soll außerdem möglichst klein sein, um zu große Leckströme durch das dünne Gatedielektrikum zu vermeiden. Herkömmliche planare Feldeffekttransistoren können diese Anforderungen nicht erfüllen.

Bspw. ist aus der deutschen Patentschrift DE 199 24 571 C2 eine Doppel-Gate-Struktur bekannt, die einen hohen Einschaltstrom ermöglicht, weil zwei Gates zur Stromsteuerung beitragen. Auch aus diesem Grund lässt sich die Betriebsspannung verringern. Dual- oder auch Trippel-Gatestrukturen sind ein erfolgversprechender Ansatz um die elektrischen Eigenschaften eines Feldeffekttransistors zu verbessern, insbesondere bei ultrakurzen Gatelängen, d.h. Gatelängen kleiner als 100 Nanometern.

Mehrfachgatestrukturen sind dreidimensionale Strukturen, so dass ihre Herstellung schwierig ist und sorgfältig optimiert werden muss. Trotz der kleinen Abmessungen soll der Flächenbedarf an Chipfläche je Transistor auch weiterhin möglichst klein sein. Die Transistoren sollen außerdem elektrische Eigenschaften wie SOI-Wafer (Silicon on Insulator) haben.

Aus der US 2002/0195649 A1 (entspricht des Präambul des Anspruchs 1) ist ein FPLA (Field Programmable Logic Arrays) bekannt, das vertikale Floating Gate Transistoren enthält, bei deren Herstellung eine Steuerelektrodenschicht planarisiert und anschließend ganzflächig rückgeätzt wird. Auch aus der US 2002/0140032 A1 und der US 6,433,382 B1 sind substratnahe Abstandsschichten von vertikalen Feldeffekttransistoren sowie deren Herstellung bekannt.

Es ist Aufgabe der Erfindung ein einfaches Verfahren zum Herstellen eines Feldeffekttransistors mit sehr guten elektrischen Eigenschaften anzugeben. Außerdem soll ein einfach herzustellender Feldeffekttransistor mit sehr guten elektrischen Eigenschaften angegeben werden, insbesondere ein FLASH-Speichertransistor.

Diese Aufgabe wird bezüglich des Verfahrens durch die im Patentanspruch 1 angegebenen Verfahrensschritte gelöst. Weiterbildungen sind in den Unteransprüchen angegeben.

Bei dem erfindungsgemäßen Verfahren werden unter anderem die folgenden Verfahrenschritte ausgeführt:
Planarisieren der Steuerelektrodenschicht, und
ganzflächiges Rückätzen der planarisierten Steuerelektrodenschicht.

Beide Schritte sind einfach auszuführen und haben zur Folge, dass die Steuerelektrode insbesondere mit einem rechteckigen oder quadratischen Querschnitt hergestellt werden kann. Insbesondere bleibt die Breite der Steuerelektrode mit zunehmendem Abstand zum Substrat gleich. Sich verjüngende Abschnitte können an der Steuerelektrode vermieden werden. Die Steuerelektrode lässt sich deshalb sehr maßhaltig und mit hoher Positioniergenauigkeit bezüglich des Vorsprungs herstellen. Deshalb werden Feldeffekttransistoren mit untereinander glei-chen und besonders guten elektrischen Eigenschaften hergestellt.

Das ganzflächige Rückätzen wird vorzugsweise anisotrop durch-geführt. Bei geeigneter Materialwahl lässt sich aber auch ein isotroper Rückätzschritt ausführen.

Das erfindungsgemäße Herstellungsverfahren wird insbesondere bei der Herstellung sogenannter vertikaler Transistoren eingesetzt, die nur einen geringen Flächenbedarf haben.

Bei einer Ausgestaltung verbleibt die Gateelektrode nach dem Abschluss des ganzflächigen Rückätzens entlang eines vollständigen Umlaufs um den Vorsprung. Damit ist das Layout eines FinFETs um 90 Grad gedreht, so dass die Finne vertikal zu einer Waferoberfläche liegt. Hat die Finne einen quadratischen oder rechteckigen Querschnitt parallel zu der Oberfläche des Chips bzw. Wafers, so entstehen an den vier Seitenwänden des Gates vier Steuerelektroden. Die den Vorsprung umschließenden Steuerelektroden führen zu einem besonders hohen Einschaltstrom. Bei einer minimalen Abmessung des Vorsprungs bspw. einer Seitenlänge kleiner als 50 Nanometer entsteht beim Betrieb des Feldeffekttransistors ein von Ladungsträgern verarmter Substratbereich wie bei einem SOI-Substrat ohne dass jedoch ein teures SOI-Substrat erforderlich ist.

Die Höhe des Vorsprungs ist so bemessen, dass die möglichst dünne Gateelektrode, und die benachbarten Abstandsschichten zur Isolation der Gateelektrode zum Source und Drain hin übereinander gestapelt kleiner als die Höhe des Vorsprungs sind. Auch Platz für eine Anschlusselektrode, insbesondere für den Sourcekontakt kann die Höhe bestimmen.

Bei einer Weiterbildung wird beim Rückätzen der planarisierten Steuerelektrodenschicht ein Teil der Struktur oder ein Teil einer die Struktur bedeckenden Isolierschicht freigelegt, so dass dieser Teil für weitere Bearbeitungsschritte und für die Anordnung weiterer Elemente zugänglich ist.

Bei einer anderen Weiterbildung wird vor dem Aufbringen der Steuerelektrodenschicht die substratnahe Abstandsschicht planarisiert und ganzflächiges rückgeätzt, wobei vorzugsweise ein Teil der Struktur freigelegt wird. Alternativ lässt sich die substratnahe Abstandsschicht aber auch nur sehr dünn aufbringen, so dass kein Rückätzen erforderlich ist. Das Rückätzen führt jedoch zu einer sehr maßhaltigen Abstandsschicht.

Bei einer nächsten Weiterbildung wird eine elektrisch isolierende substratferne Abstandsschicht nach dem Rückätzen der Steuerelektrodenschicht aufgebracht, planarisiert und ganzflächig rückgeätzt. Insbesondere durch das wiederholte planarisieren und rückätzen bei nacheinander aufgebrachten Schichten lässt sich eine maßhaltige dreidimensional Integration erreichen.

Bei einer Ausgestaltung ist die Dicke der unteren Abstandsschicht ungleich der Dicke der oberen Abstandsschicht. Dies hat Vorteile bei der Optimierung der Transistoren. In einem normalen CMOS Flow sind unterschiedliche Dicken nicht so einfach zu realisieren.

Bei einer anderen Weiterbildung wird nach dem Aufbringen der substratfernen Abstandsschicht eine Anschlusselektrodenschicht aufgebracht, vorzugsweise eine Sourceschicht. Die Sourceschicht bedeckt vorzugsweise die Seitenwände des Vorsprungs, so dass die Kontaktfläche vergrößert ist. Bei einer Ausgestaltung wird die Anschlusselektrodenschicht noch planarisiert, so dass sie anschließend ohne Problem strukturiert werden kann.

Bei einer Weiterbildung des erfindungsgemäßen Verfahrens werden die substratnahe Abstandsschicht, die Steuerelektrodenschicht und die substratferne Abstandsschicht sowie die Anschlusselektrodenschicht gemeinsam strukturiert, bspw. mit einem fotolithografischen Verfahren oder mit einer Spacertechnik. Die Anzahl der Herstellungsschritte ist dadurch klein.

Bei einer anderen Weiterbildung wird eine elektrisch isolierende Schicht an einem Teil der Struktur nach dem Rückätzen der substratnahen Abstandsschicht und vor dem Aufbringen der Steuerelektrodenschicht als Gatedielektrikum aufgebracht, insbesondere durch eine ganzflächige Schichtabscheidung, bspw. eines Materials mit einer relativen Dielektrizitätskonstante größer 4 oder größer 8, oder durch ein thermisches Aufwachsen, bspw. eine thermische Oxidation.

Bei einer nächsten Weiterbildung wird die Struktur mit Hilfe einer Hartmaske ausgebildet, wobei die Hartmaske bei allen genannten Planarisierungsschritten als Stoppschicht verwendet wird. Damit kann sehr genau auf einer vorgegebenen Höhe gestoppt werden. Ausgehend von dieser Höhe lässt sich dann ein zeitgesteuerter Rückätzprozess ausführen, bei dem sich eine rückgeätzte Schicht mit einer Schichtdicke in einem kleinen Toleranzbereich herstellen lässt.

Bei einer Weiterbildung wird nach dem Aufbringen der substratnahen Abstandsschicht und vor dem Aufbringen der Steuerelektrodenschicht eine Ladungsspeicherschicht aufgebracht. Die Ladungsspeicherschicht wird vor dem Aufbringen der Steuerelektrodenschicht strukturiert. Die Ladungsspeicherschicht ist elektrisch leitfähig, z.B. metallisch, halbleitend oder elektrisch isolierend. Bei einer elektrisch isolierenden Ladungsspeicherschicht werden die Ladungen insbesondere mit Hilfe von Tunnelströmen eingebracht. Bei der Weiterbildung entsteht bspw. eine EEPROM (Electrical Erasable Programmable Read Only Memory) Zelle, die unabhängig von benachbarten Zellen gelöscht werden kann, oder eine Flash EPROM-Zelle, die nur gemeinsam mit benachbarten Zellen gelöscht werden kann. Bei einer Ausgestaltung werden in der Speichereinheit "vergrabene" (buried) Bitleitungen eingesetzt, die durch Substratdotierungen hergestellt sind.

Die Speichereinheit ist bspw. als NOR-Typ oder als SNOR organisiert. Zum Löschen werden Tunnelströme eingesetzt, insbesondere Fowler Nordheim Tunnelströme (FN). Zum Programmieren werden Tunnelströme oder heiße Ladungsträger (CHE - Channel Hot Electron) eingesetzt. Die maßhaltige Fertigung auf Grund des einfachen oder mehrfachen Planarisierens und Rückätzens führt zu hervorragenden elektrischen Eigenschaften der Speicherzelle, insbesondere hinsichtlich der Programmiersicherheit, der Anzahl der Programmierzyklen und hinsichtlich der Verschiebung der Schwellspannung.

Bei einer Weiterbildung des Verfahrens wird die Ladungsspeicherschicht planarisiert und anschließend ganzflächig zurückgeätzt, wobei vorzugsweise eine Teil der Struktur oder ein Teil der Isolierschicht freigelegt wird. Durch diese Schritte lässt sich eine Ladungsspeicherschicht mit einer Deckfläche herstellen, die parallel zu einer Substratfläche bzw. zu der Basisfläche liegt. Eine solche Ladungsspeicherschicht führt zu definierten Programmier- und Löschvorgängen. Bei einer Weiterbildung wird mindestens ein Abstandselement an der Struktur und auf der Ladungsspeicherschicht ausgebildet. Das Abstandselement dient dann zum Strukturieren der Ladungsspeicherschicht, so dass eine einfache selbstausrichtende Spacertechnik zur Strukturierung genutzt wird.

Ein gemäß der Erfindung hergestellten vertikaler Feldeffekt-transistor hat eine Steuerelektrode mit ebener substratferner Grenzfläche, die parallel zu einer substratnahen Basisfläche des Vorsprungs liegt. Bei einer Weiterbildung wird die Steuerelektrode in der vom Substrat wegzeigenden Normalenrichtung der Basisfläche überall von der ebenen Grenzfläche begrenzt wird. Mit anderen Worten ausgedrückt gibt es nach "oben" hin keine geneigten Grenzflächen bzw. sich nach oben hin verjüngende Vorsprünge, die die elektrischen Eigenschaften des Transistors weniger kontrollierbar machen würden.

Bei einer anderen Weiterbildung hat der Feldeffekttransistor mindestens einen zwischen einem Isolierbereich und einem Steuerelektrodenbereich angeordneten Ladungsspeicherbereich, mit einer substratfernen ebenen Grenzfläche, die parallel zu der Basisfläche des Vorsprungs liegt. Damit entsteht ein Speichertransistor mit definierten und gut kontrollierbaren elektrischen Eigenschaften. Der Feldeffekttransistor wird bei einer Ausgestaltung als Seitenwandtransistor bzw. als sogenannter Surrounded-Gate-Transistor ausgebildet.

Insbesondere sind die Feldeffekttransistoren mit dem erfindungsgemäßen Verfahren oder einer seiner Weiterbildungen hergestellt worden, so dass die oben genannten technischen Wirkungen gelten.

Im folgenden werden Ausführungsbeispiele der Erfindung an Hand der beiliegenden Zeichnungen erläutert. Darin zeigen:
- Figur 1: eine vereinfachte Darstellung eines Seitenwand- Feldeffekttransistor,
- Figur 2: eine Draufsicht auf den Feldeffekttransistor,
- Figuren 3A und 3B: Herstellungsstufen bei der Herstellung des Feldeffekttransistors,
- Figur 4: eine alternative Herstellungsstufe bei der Her- stellung des Feldeffekttransistors,
- Figuren 5A und 5B: Herstellungsstufen bei der Herstellung eines Seitenwand Flash-Feldeffekttransistors.

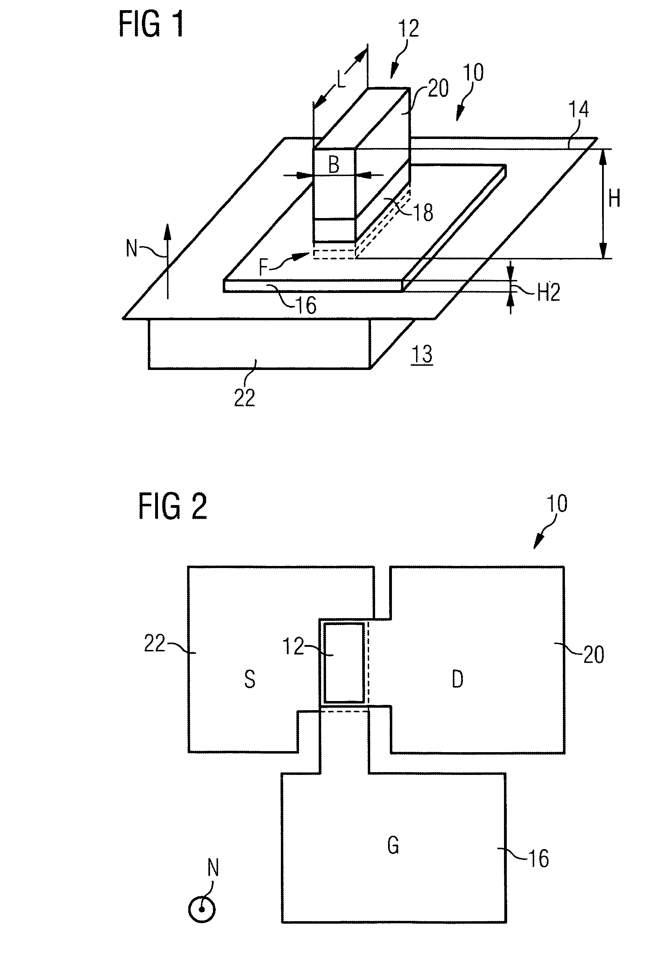

Figur 1 zeigt einen vertikalen Finnen-Feldeffekttransistor 10, der an einer Finne 12 ausgebildet ist. Die Finne 12 wurde aus einem Halbleiter-Substrat 13 herausgeätzt, das nach dem Ätzen eine ebene Substratoberfläche 14 hat. Beispielsweise wird ein Siliziumsubstrat verwendet, das anfangs vordotiert oder undotiert ist. Die Finne 12 hat bspw. ein Höhe H von 100 Nanometern in Normalenrichtung N der Substratoberfläche 14.

Die Breite B der Finne 12 beträgt bspw. 20 Nanometer. Die Länge L der Finne 12 beträgt bspw. 60 Nanometer.

Am Fuß F der Finne 12 bzw. an der Basis der Finne 12 befindet sich in der Ebene der Substratoberfläche 14 eine Basisfläche der Finne 12. Eine Gateelektrode 16 umschließt die Finne 12 und liegt parallel und mit Abstand zur Substratoberfläche 14. Der Abstand beträgt bspw. 30 Nanometer. Die Gateelektrode 16 besteht bspw. aus dotiertem polykristallinem Silizium.

Zwischen der Gateelektrode 16 und der Finne 12 befindet sich ein in Figur 1 nicht dargestelltes Gatedielektrikum 18. Geeignete Gatedielektrika sind bspw. Siliziumdioxid oder isolierende Materialien mit einer relativen Dielektrizitätskonstante größer als 3,9 oder größer als 7, d.h. sogenannte high-k-Materialien.

Im oberen Teil der Finne 12 ist ein Drainbereich 20 angeordnet, der bei einem n-Kanaltransistor n-dotiert und bei einem p-Kanaltransistor p-dotiert ist. Um die Basisfläche am Fuß F der Finne 12 herum ist im Substrat 13 unmittelbar unterhalb der bzw. angrenzend an die Substratoberfläche 14 ein Sourcebereich 22 angeordnet, der bspw. die gleiche Dotierung wie der Drainbereich 20 hat. Bei einem anderen Ausführungsbeispiel ist der Sourcebereich in der Finne 12 und der Drainbereich im Substrat angeordnet. Die Dotierung von Source und Drain sind bei einem andren Ausführungsbeispiel unterschiedlich, um ein gutes Optimieren der Transistoren erlauben. Die Höhe H der Finne 12 wird durch die Höhe zweier Abstandselemente zur Isolierung der Gateelektrode 16 gegen die Substratoberfläche 14 bzw. gegen einen Drainanschluss, durch die Höhe H2 der Gateelektrode und durch die Höhe eines Drainanschlusses bestimmt.

Figur 2 zeigt eine Draufsicht auf den Feldeffekttransistor 10 mit einer Fläche S für den Sourcebereich 22 bzw. für einen Sourceanschlussbereich, mit einer Fläche G für die Gateelektrode bzw. für einen Gateelektrodenanschlussbereich und mit einer Fläche D für den Drainbereich bzw. für einen Drainanschlussbereich. Die Anschlussbereiche sind quadratisch bzw. rechteckförmig und liegen an verschiedenen Seiten der Finne 12. Auch der Drainanschlussbereich D umschließt die Finne 12. Damit ist der Feldeffekttransistor 10 ein vertikaler Feldeffekttransistor mit vier Steuerelektroden bzw. Gatebereichen und mit einer geringen Bauhöhe.

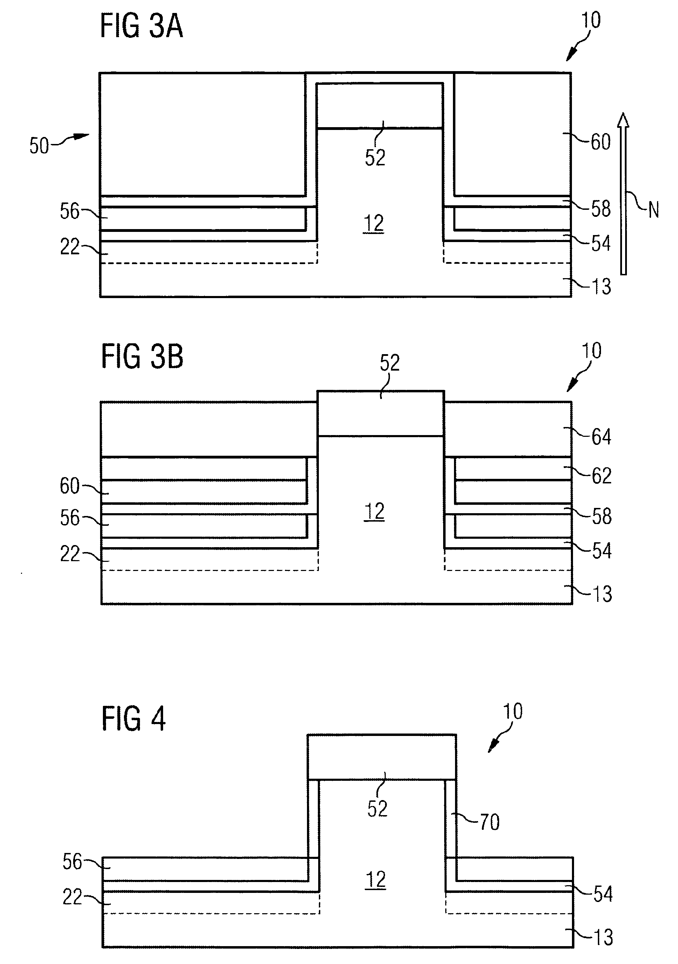

Figur 3A zeigt eine Herstellungsstufe bei der Herstellung des Feldeffekttransistors 10. Ausgehend von dem Substrat 13 werden nicht dargestellte flache Isoliergräben hergestellt, die zur Isolierung von Transistoren untereinander dienen. Die Isoliergräben werden auf bekannte Weise mit einem Isoliermaterial gefüllt, z.B. mit Siliziumdioxid. Nach dem Füllen wird planarisiert, bspw. mittels eines chemisch mechanischen Polierverfahrens CMP.

Nach dem Planarisieren wird eine Hartmaskenschicht 50 abgeschieden, z.B. eine Siliziumnitridschicht. Die Hartmaskenschicht 50 wird bspw. mit Hilfe eines fotolithografischen Verfahrens oder mir Hilfe einer Spacertechnik strukturiert, wobei im Bereich, in dem der Transistor 10 erzeugt werden soll, eine Hartmaske 52 verbleibt. An anderen Stellen des Substrats 13 verbleiben zur Herstellung einer Vielzahl anderer Transistoren weitere Hartmaskenabschnitte. Die Transistoren werden mit den gleichen Verfahrensschritten hergestellt und sind deshalb gleich aufgebaut. Die Hartmaske 52 hat beispielsweise die oben genannte Ausdehnung von 20 Nanometer mal 60 Nanometer.

Nach dem Strukturieren der Hartmaskenschicht 50 wird bspw. mit dem gleichen Ätzverfahren das Substrat 13 gemäß der Hartmaske strukturiert. Dabei wird die Finne 12 erzeugt. Es wird zeitgesteuert mit einem bekannten Ätzverfahren geätzt. Die Hartmaskenschicht wird beim Ätzen ggf. auch etwas gedünnt. Nach dem Erzeugen der Finne hat die Hartmaskenschicht 50 bspw. eine Dicke von 40 Nanometern.

Anschließend wird eine dünne Streu-Oxidschicht 54 erzeugt, um u.a. das Substrat bei den folgenden Sourceimplantationsschritten zu schützen. Die Oxidschicht 54 wird bspw. mit einer thermischen Oxidation in einer Dicke von bspw. kleiner 10 Nanometer erzeugt.

Danach wird der Sourcebereich 22 bzw S mit Hilfe einer Implantation hoch dotiert, wobei eine niedrige bis mittlere Beschleunigungsspannung eingesetzt wird.

Nach dem Implantieren wird eine elektrisch isolierende Abstandsschicht 56 mit einer Dicke abgeschieden, die höher als die Höhe H der Finne 12 plus die Dicke der Hartmaske 52 ist. Bspw. ist die Abstandsschicht 56 eine Siliziumdioxidschicht mit einer ursprünglichen Dicke von 140 Nanometern. Die Abstandsschicht 56 wird planarisiert, z.B. mit Hilfe eines chemisch mechanischen Polierverfahrens, wobei auf der Hartmaske 52 bzw. auf den Resten der Hartmaskenschicht 50 an nicht gezeigten CMP-Hilfsstrukturen gestoppt wird.

Nach dem Planarisieren wird die Abstandsschicht 56 ganzflächig auf ihre Zieldicke zurückgeätzt, bspw. auf 30 Nanometer oder auf eine Dicke im Bereich von 30 Nanometern bis 50 Nanometern. Die Ätzung wird bspw. zeitgesteuert durchgeführt.

In dem rückgeätzten Bereich wird bspw. mit einer zusätzlichen isotropen Oxidätzung im Ausführungsbeispiel auch die dünne Streu-Oxidschicht 54 von den vertikalen Flanken der geätzten Struktur entfernt. Damit liegen die Seitenflächen der Finne 12 wieder frei.

Danach wird eine Gatedielektrikumschicht 58 abgeschieden, bspw. durch Sputtern oder Dampfphasenabscheidung CVD (Chemical Vapor Deposition). Die Gatedielektrikumschicht 58 besteht bspw. aus Oxynitrid oder einem anderen high-k-Material. Die Oxid-äquivalente Dicke der Gatedielektrikumschicht 58 liegt im Ausführungsbeispiel bei 1 Nanometer. Alternativ liegt die Dicke der Gatedielektrikumschicht 58 bspw. im Bereich von 1 Nanometer bis 2 Nanometern.

Wie weiter in Figur 3A gezeigt, wird anschließend eine Gateelektrodenschicht 60 aufgebracht, insbesondere abgeschieden. Die Gateelektrodenschicht 60 besteht bspw. aus einem Metall oder aus hoch dotiertem polykristallinem Silizium. Die Gateelektrodenschicht 60 hat am Ende des Aufbringens eine Dicke, die größer ist als der Abstand in Normalenrichtung N von der substratfernen Oberfläche der nicht auf der Hartmaske 52 liegenden Bereiche der Gatedielektrikumschicht 58 bis zur substratfernen Oberfläche der Hartmaske 52. Aussparungen zwischen benachbarten Finnen 12 einschließlich Hartmasken 52 werden also vollständig mit dem Material der Gateelektrodenschicht 60 gefüllt. Im Ausführungsbeispiel wird die Gateelektrodenschicht 60 mit einer Dicke von 110 Nanometern aufgebracht.

Nach dem Aufbringen der Gateelektrodenschicht 60 wird wiederum planarisiert, bspw. mit Hilfe eines CMP-Verfahrens, wobei auf der Hartmaske 52 bzw. dem auf der Hartmaske 52 aufliegenden Teil der Elektrodenschicht gestoppt wird.

Wie in Figur 3B gezeigt, wird die planarisierte Gateelektrodenschicht 60 danach ganzflächig zurückgeätzt, insbesondere unter Verwendung eines anisotropen Ätzverfahrens. Ganzflächig bedeutet dabei, dass keine Maske zur Strukturierung der Gateelektrodenschicht 60 bei dem Rückätzschritt verwendet wird. Die Zeitdauer für das Rückätzen bestimmt die verbleibende Dicke der Gateelektrodenschicht 60. Im Ausführungsbeispiel ist die Gateelektrodenschicht 60 nach dem Rückätzen bspw. noch 20 Nanometer dick. Auf Grund des dem Rückätzen vorangehenden Planarisierens hat die rückgeätzte Gateelektrodenschicht 60 eine gleichbleibende Schichtdicke. Die Gateelektrodenschicht 60 wird also bis unter die substratferne Oberfläche der Hartmaske 52 und auch unterhalb der substratfernen Oberfläche der Finne 12 zurückgeätzt.

Nach dem Rückätzen oder auch vor dem Rückätzen der Gateelektrodenschicht 60 kann die Gateelektrodenschicht 60 und vorzugsweise auch die Abstandsschicht 56 bereits mit einem lithografischen Verfahren oder mit einer Spacertechnik strukturiert werden, d.h. also unter Verwendung einer Maske. Alternativ wird das Strukturieren der Gateelektrodenschicht 60 und ggf. auch der Abstandsschicht 56 jedoch zu einem späteren Zeitpunkt gemeinsam mit mindestens einer nach dem Aufbringen der Gateelektrodenschicht 60 aufgebrachten Schicht durchgeführt. Bei der Strukturierung der Gateelektrodenschicht 60 entsteht die Gateelektrodenanschlussschicht 16.

Wie weiter in Figur 3B gezeigt, wird nach dem Rückätzen der Gateelektrodenschicht 60 eine zweite elektrisch isolierende Abstandsschicht 62 aufgebracht, bspw. durch eine abgeschieden. Die zweite Abstandsschicht 62 besteht im Ausführungsbeispiel aus dem gleichen Material wie die dem Substrat 13 nähere Abstandsschicht 56. Alternativ bestehen die Abstandsschichten 56 und 62 jedoch aus voneinander verschiedenen Materialien.

Die Abstandsschicht 62 wird ebenfalls in einer Dicke aufgebracht, die größer als die Höhendifferenz der subsubstratfernen Oberfläche der Hartmaske 52 bzw. der subsubstratfernen Oberfläche der auf der Hartmaske verbliebenen Gatedielektrikumschicht 58 und der substratfernen Oberfläche der rückgeätzten Gateelektrodenschicht 60. Im Ausführungsbeispiel beträgt die Dicke der Abstandsschicht unmittelbar nach dem Aufbringen 90 Nanometer.

Die Abstandsschicht 62 wird anschließend ganzflächig rückgeätzt auf eine Zieldicke von bspw. 30 Nanometer, so dass die substratferne Oberfläche der Abstandsschicht 62 ca. 10 Nanometer unterhalb des freien Endes der Finne 12 liegt.

In einem weiteren Verfahrensschritt wird, wie ebenfalls in Figur 3B dargestellt, das freiliegende Gatedielektrikum 58 von den noch nicht bedeckten Flächen der Finne 12 und von der Hartmaske 52 entfernt, bspw. trockenchemisch oder nasschemisch. Damit liegt ein Anschlussbereich zur Kontaktierung des Drainbereiches am freien Ende der Finne 12 frei. Optional wird auch die verbliebene Hartmaske 52 nasschemisch entfernt.

Anschließend wird ein Drainkontaktmaterial 64 abgeschieden, vorzugsweise in einer Dicke die größer als die verbliebene Höhendifferenz ist, um die die Finne 12 bzw. um die die Hartmaske 52 die Abstandsschicht 62 überragt. Das Drainkontaktmaterial 64 ist bspw. hochdotiertes polykristallines Silizium. Optional wird das Drainkontaktmaterial 64 danach planarisiert und ganzflächig rückgeätzt.

Das Drainkontaktmaterial wird anschließend mit einem Lithografieverfahren strukturiert. Schritte zum Herstellen von Metallkontakten schließen sich optional an. Beim Abscheiden des Drainkontaktmaterials 64 bzw. bei nachfolgenden Temperaturschritten diffundiert Dotierstoff aus der Drainschicht 64 in die Finne 12, um das Draingebiet zu bilden. Gleichzeitig diffundiert Dotierstoff aus dem Sourcebereich in den unteren Bereich der Finne, um den Sourceanschluss an den Kanal zu bilden. Beim Strukturieren entsteht aus dem Drainkontaktmaterial 64 der Drainbereich 20.

Figur 4 zeigt eine alternative Herstellungsstufe bei der Herstellung des Feldeffekttransistors 10. An Stelle der Abscheidung einer Gatedielektrikumschicht 58 wird nach dem Rückätzen der Abstandsschicht 56 ein Gatedielektrikum 70 nur an den frei liegenden Seitenwänden der Finne 12 aufgebracht, insbesondere durch eine thermische Oxidation. Alternativ wird nur an den Seitenwänden der Finne 12 eine Oxynitridschicht erzeugt. Danach werden die gleichen Herstellungsschritte ausgeführt, wie sie an Hand der Figuren 3A und 3B erläutert worden sind.

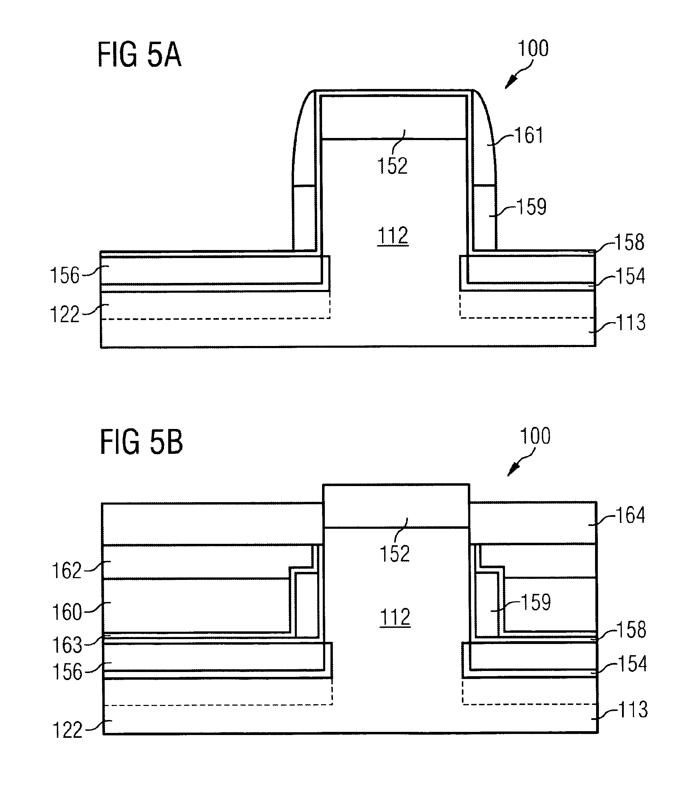

Figuren 5A und 5B zeigen Herstellungsstufen bei der Herstellung eines vertikalen Seitenwand Flash-Feldeffekt-Transistors 100. Bei der Herstellung des Transistors 100 wird bspw. bis auf die im Folgenden erläuterten zusätzlichen Verfahrensschritte zur Herstellung einer Ladungsspeicherschicht bzw. eines sogenannten Floating Gates wie bei der Herstellung des Transistors 10 bzw. der genannten Alternativen vorgegangen.

Insbesondere werden dabei wieder die folgenden Verfahrensschritte in der genannten Reihenfolge ausgeführt:
- ausgehend von einem Substrat 113 wird mit einer Hartmaske 152 bzw. mit einer anderen Technik eine Finne 112 mit den gleichen Abmessungen wie die Finne 12 erzeugt,
- eine dünne Streuoxidschicht 154 wird aufgebracht,
- Sourcebereiche 122 werden implantiert,
- eine elektrisch isolierende planare Abstandsschicht 156 wird vorzugsweise durch Abscheiden, Planarisieren und ganzflächiges Rückätzen erzeugt,
- eine erste Gatedielektrikumschicht 158 wird durch ganzflächige Abscheidung wie die Gatedielektrikumschicht 58 erzeugt. Alternativ wird nur an der Finne 112 ein Gatedielektrikum entsprechend dem Gatedielektrikum 70 erzeugt.

Wie in Figur 5A gezeigt, werden nach dem Erzeugen des ersten Gatedielektrikums Schritte zur Herstellung eines Ladungsspeicherbereiches 159 durchgeführt. Dazu wird bspw. eine hochdotierte polykristalline Siliziumschicht abgeschieden. alternativ kann auch ein dielektrisches Material oder ein Metall als Material für den Ladungsspeicherbereich dienen. Die Schicht zur Herstellung des Ladungsspeicherbereiches 159 wird mit einer Dicke abgeschieden, die ein anschließendes vollständiges Planarisieren ermöglicht. Bspw. beträgt die Schichtdicke nach dem Aufbringen 110 Nanometer.

Das Material zur Herstellung des Ladungsspeicherbereiches 159 wird anschließend planarisiert, bspw. mittels CMP, wobei vorzugsweise CMP-Stoppstrukturen als Stopp dienen. Danach wird ganzflächig zurückgeätzt, wobei die verbleibende Dicke der Schicht zur Ausbildung des Ladungsspeicherbereiches 159 bspw. noch 30 Nanometer beträgt.

Wie weiter in Figur 5A gezeigt, wird anschließend durch eine Schichtabscheidung und ein anisotropes Ätzen ein Abstandselement 161 bzw. ein Spacer erzeugt, das an den mit dem Gatedielektrikum bedeckten Seitewänden die Finne 112 und ggf. die mit Gatedielektrikum bedeckten Seitenwände der Hartmaske 152 umschließt. Das Abstandselement 161 liegt auf der Schicht zur Ausbildung des Ladungsspeicherbereiches auf.

Anschließend wird die Schicht zur Ausbildung des Ladungsspeicheerbereiches 159 mit Hilfe des Abstandselementes 161 als Hartmaske in einem anisotropen Ätzprozess strukturiert. Danach wird das Abstandselement 161 entfernt. Die Hartmaske 152 verbleibt im Ausführungsbeispiel weiter auf der Finne 112.

Wie in Figur 5B gezeigt, wird danach eine weitere Dielektrikumschicht 163 erzeugt. Anschließend werden die gleichen Verfahrensschritte wie zur Herstellung des Transistors 10 durchgeführt, insbesondere:
- Herstellen einer elektrisch leitfähigen Gateelektrodenschicht 160, bspw. aus hochdotiertem polykristallinem Silizium, durch Abscheiden, Planarisieren und ganzflächiges Rückätzen. Die Dicke und das Material der Gateelektrodenschicht 160 gleichen bspw. der Dicke und dem Material der Gateelektrodenschicht 60. Die Gateelektrodenschicht 160 ist im Ausführungsbeispiel weiter zurückgeätzt worden als der Ladungsspeicherbereich 159. Alternativ wird aber die Gateelektrodenschicht 160 weniger weit zurückgeätzt, so dass sie den Ladungsspeicherbereich 159 überlappt.
- anschließend Erzeugen einer weiteren elektrisch isolierenden Abstandsschicht 162, die in ihrer Dicke und in ihrem Material der Abstandsschicht 62 gleicht oder gleichen kann. Es können aber auch andere Materialien oder eine andere Dicke der Abstandsschicht verwendet werden.
- Strukturieren der Gateelektrodenschicht 160 und der Abstandsschicht 162 z.B. mit einem fotolithografischen Verfahren.
- Beseitigen der beiden Gatedielektrika oberhalb der Abstandsschicht 162,
- optional Entfernen der verbliebenen Hartmaske 152
- Aufbringen von Drainkontaktmaterial 164, das dem Drainkontaktmaterial 64 entspricht, vorzugsweise durch Abscheiden, Planarisieren und ganzflächiges Rückätzen, wodurch sich die Drain-Gate-Kapazität verringert.
- Strukturieren des Drainkontaktmaterials 164.

Die Flash-Zelle wird vorzugsweise mit "heißen" Ladungsträgern programmiert, die auch CHE bzw. Channel Hot Electrons bezeichnet werden. Zum Löschen werden vorzugsweise Fowler-Nordheim-Tunnelströme eingesetzt. Die Flashzellen sind bspw. gemäß der bekannten NOR-Struktur organisiert. Das bedeutet, dass die Sourceanschlüsse als Bitleitungen in einer Bitleitungsrichtung strukturiert sind. Im rechten Winkel zu den Bitleitungen verlaufen Wortleitungen, die durch Strukturierung der Gateelektroden entstanden sind. An jeder Bitleitung bzw. Wortleitung liegen eine Vielzahl von Speichertransistoren eines matrixförmig aufgebauten Speicherzellenfeldes.

Bei anderen Ausführungsbeispielen wird keine Hartmaske 52, 152 verwendet, bzw. die Hartmaske 52, 152 wird frühzeitig entfernt, so dass als Bezugspunkt für die Dicke der zu planarisierenden Schichten das Ende der Finne 12 bzw. 112 dient.

Auf Grund der vergrabenen Sourcebereiche 122 benötigt der Transistor 100 nur ein kleine Substratfläche. Außerdem ermöglichen die vier Gatebereiche einen großen Einschaltstrom, so dass eine verringerte Betriebsspannung genutzt werden kann, die bspw. kleiner als 3 Volt ist. Die angegebenen Herstellungsverfahren sind einfach und ermöglichen die in sehr engen Toleranzen reproduzierbare Herstellung von Transistoren.

## Patentansprüche

1. Verfahren zum Herstellen eines vertikalen Feldeffekttransistors (10, 100),
mit den Schritten:
an einem Substrat (13, 113) Ausbilden mindestens einer Struktur (12, 112), die zur Ausbildung des Kanalbereiches eines Feldeffekttransistors (10, 100) dient,
Aufbringen einer elektrisch isolierenden substratnahen Abstandsschicht (56, 156) nach dem Ausbilden der Struktur (12, 112),
nach dem Aufbringen der substratnahen Abstandsschicht (56, 156) Aufbringen einer elektrisch leitfähigen oder halbleitenden Steuerelektrodenschicht (60, 160), die zur Ausbildung der Steuerelektrode des Feldeffekttransistors (10, 100) dient, Planarisieren der Steuerelektrodenschicht (60, 160), und
ganzflächiges Rückätzen der planarisierten Steuerelektrodenschicht (60, 160),
**gekennzeichnet durch** die vor dem Aufbringen der Steuerelektrodenschicht (60, 160) ausgeführten Schritte: Planarisieren der substratnahen Abstandsschicht (56, 156), nach dem Planarisieren der substratnahen Abstandsschicht (56, 156) ganzflächiges Rückätzen der substratnahen Abstandsschicht (56, 156),
**oder durch** die Schritte:
Aufbringen einer elektrisch isolierenden substratfernen Abstandsschicht (62, 162) nach dem Rückätzen der Steuerelektrodenschicht (60, 160),
Planarisieren der substratfernen Abstandsschicht (62, 162), ganzflächiges Rückätzen der substratfernen Abstandsschicht (62, 162).

2. Verfahren nach Anspruch 1, **dadurch gekennzeichnet, dass** beim Rückätzen der planarisierten Steuerelektrodenschicht (60, 160) ein Teil der Struktur (12, 112) oder ein Teil einer die Struktur (12, 112) bedeckenden Isolierschicht (58, 70, 163) freigelegt wird.

3. Verfahren nach Anspruch 1 oder 2, **dadurch ge** - **kennzeichnet**, dass beim ganzflächiges Rückätzen der substratnahen Abstandsschicht (56, 156) ein Teil der Struktur (12, 112) freigelegt wird.

4. Verfahren nach einem der vorhergehenden Ansprüche, **dadurch gekennzeichnet, dass** beim ganzflächiges Rückätzen der substratfernen Abstandsschicht (62, 162), ein Teil der Struktur (12, 112) oder ein Teil einer die Struktur (12, 112) bedeckenden Isolierschicht (58, 70, 163) freigelegt wird.

5. Verfahren nach einem der vorhergehenden Ansprüche, **gekennzeichnet durch** mindestens einen der Schritte:
nach dem Aufbringen der substratfernen Abstandsschicht (62, 162) Aufbringen einer Anschlusselektrodenschicht (64, 164), die zum Ausbilden einer Anschlusselektrode des Feldeffekttransistors (10, 100) dient,
Planarisieren der Anschlusselektrodenschicht (64, 164).

6. Verfahren nach Anspruch 5, **gekennzeichnet durch** den Schritt:
gemeinsames Strukturieren der Steuerelektrodenschicht (60, 160) und der substratfernen Abstandsschicht (62, 162) und vorzugsweise auch der substratnahen Abstandsschicht (56, 156).

7. Verfahren nach einem der vorhergehenden Ansprüche, **gekennzeichnet durch** den Schritt:
Ausbilden einer elektrisch isolierenden Schicht (58, 70, 163) an einem Teil der Struktur (12, 112) nach dem Rückätzen der substratnahen Abstandsschicht (56, 156) und vor dem Aufbringen der Steuerelektrodenschicht (60, 160).

8. Verfahren nach Anspruch 7, **dadurch gekennzeichnet, dass** die elektrisch isolierende Schicht (58, 70, 163) durch ganzflächige Schichtabscheidung oder durch ein thermisches Aufwachsen hergestellt wird, insbesondere durch eine thermische Oxidation.

9. Verfahren nach einem der vorhergehenden Ansprüche, **da** - **durch gekennzeichnet**, dass die Struktur (12, 112) mit Hilfe einer Hartmaske (52, 152) ausgebildet wird, wobei die Hartmaske (52, 152) vorzugsweise bei mindestens einem Planarisierungsschritt oder bei allen genannten Planarisierungsschritten als Stoppschicht verwendet wird.

10. Verfahren nach einem der vorhergehenden Ansprüche, **gekennzeichnet durch** mindestens einen der Schritte:
Aufbringen einer Ladungsspeicherschicht (159) nach dem Aufbringen der substratnahen Abstandsschicht (56, 156) und vor dem Aufbringen der Steuerelektrodenschicht (60, 160),
Strukturieren der Ladungsspeicherschicht (159) vor dem Aufbringen der Steuerelektrodenschicht (60, 160).

11. Verfahren nach Anspruch 10, **gekennzeichnet durch** mindestens einen der Schritte:
Planarisieren der Ladungsspeicherschicht (159),
ganzflächiges Rückätzen der Ladungsspeicherschicht (159), wobei vorzugsweise eine Teil der Struktur (112) oder ein Teil einer die Struktur (112) bedeckenden Isolierschicht (158) freigelegt wird,
Ausbilden mindestens eines Abstandselementes (161) an der Struktur (112),
Strukturieren der Ladungsspeicherschicht (159) unter Verwendung des Abstandselementes (161).

## Claims

1. A method for producing a vertical field effect transistor (10, 100),
having the following steps:
on a substrate (13, 113) formation of at least one structure (12, 112) which serves for forming the channel region of a field effect transistor (10, 100),
application of an electrically insulating spacer layer (56, 156) near to the substrate after the formation of the structure (12, 112),
after the application of the spacer layer (56, 156) near to the substrate, application of an electrically conductive or semiconducting control electrode layer (60, 160), which serves for forming the control electrode of the field effect transistor (10, 100),
planarization of the control electrode layer (60, 160), and
whole-area etching-back of the planarized control electrode layer (60, 160),
**characterized by** the following steps performed prior to the application of the control electrode layer (60, 160):
planarization of the spacer layer (56, 156) near to the substrate,
after the planarization of the spacer layer (56, 156) near to the substrate whole-area etching-back of the spacer layer (56, 156) near to the substrate,
or by the following steps:
application of an electrically insulating spacer layer (62, 162) remote from the substrate after the etching-back of the control electrode layer (60, 160),
planarization of the spacer layer (62, 162) remote from the substrate,
whole-area etching-back of the spacer layer (62, 162) remote from the substrate.

2. The method as claimed in claim 1, **characterized in that** a part of the structure (12, 112) or a part of an insulating layer (58, 70, 163) covering the structure (12, 112) is uncovered during the etching-back of the planarized control electrode layer (60, 160).

3. The method as claimed in claim 1 or 2, **characterized in that** a part of the structure (12, 112) is uncovered during the whole-area etching-back of the spacer layer (56, 156) near to the substrate.

4. The method as claimed in one of the preceding claims, **characterized in that** a part of the structure (12, 112) or a part of an insulating layer (58, 70, 163) covering the structure (12, 112) is uncovered during the whole-area etching-back of the spacer layer (62, 162) remote from the substrate.

5. The method as claimed in one of the preceding claims, **characterized by** at least one of the following steps:
after the application of the spacer layer (62, 162) remote from the substrate, application of a connection electrode layer (64, 164) serving for forming a connection electrode of the field effect transistor (10, 100),
planarization of the connection electrode layer (64, 164).

6. The method as claimed in claim 5, **characterized by** the following step:
joint patterning of the control electrode layer (60, 160) and of the spacer layer (62, 162) remote from the substrate and preferably also of the spacer layer (56, 156) near to the substrate.

7. The method as claimed in one of the preceding claims, **characterized by** the following step:
formation of an electrically insulating layer (58, 70, 163) on a part of the structure (12, 112) after the etching-back of the spacer layer (56, 156) near to the substrate and prior to the application of the control electrode layer (60, 160).

8. The method as claimed in claim 7, **characterized in that** the electrically insulating layer (58, 70, 163) is produced by whole-area layer deposition or by thermal growth, in particular by a thermal oxidation.

9. The method as claimed in one of the preceding claims, **characterized in that** the structure (12, 112) is formed with the aid of a hard mask (52, 152), the hard mask (52, 152) preferably being used as a stop layer during at least one planarization step or during all the planarization steps mentioned.

10. The method as claimed in one of the preceding claims, **characterized by** at least one of the following steps:
application of a charge storage layer (159) after the application of the spacer layer (56, 156) near to the substrate and prior to the application of the control electrode layer (60, 160),
patterning of the charge storage layer (159) prior to the application of the control electrode layer (60, 160).

11. The method as claimed in claim 10, **characterized by** at least one of the following steps:
planarization of the charge storage layer (159),
whole-area etching-back of the charge storage layer (159),
preferably a part of the structure (112) or a part of an insulating layer (158) covering the structure (112) being uncovered,
formation of at least one spacer element (161) on the structure (112),
patterning of the charge storage layer (159) using the spacer element (161).

## Revendications

1. Procédé de production d'un transistor (10, 100) vertical à effet de champ,
comprenant les stades, dans lesquels :
on forme sur un substrat (13, 113) au moins une structure (12, 112), qui sert à la formation de la zone de canal d'un transistor (10, 100) à effet de champ,
on dépose une couche (56, 156) de mise à distance isolante électriquement et proche du substrat après la formation de la structure (12, 112),
après le dépôt de la couche (56, 156) de mise à distance proche du substrat, on dépose une couche (60, 160) d'électrode de commande conductrice de l'électricité ou semiconductrice, qui sert à la formation de l'électrode de commande du transistor (10, 100) à effet de champ, on planarise la couche (60, 160) d'électrode de commande et on attaque en retrait sur toute la surface la couche (60, 160) d'électrode de commande planarisée,
**caractérisé par** les stades effectués avant le dépôt de la couche (60, 160) d'électrode de commande :
on planarise la couche (56, 156) de mise à distance proche du substrat après la planarisation de la couche (56, 156) de mise à distance proche du substrat, on attaque en retrait sur toute la surface la couche (56, 156) de mise à distance proche du substrat,
ou par les stades :
on dépose une couche (62, 162) de mise à distance isolante électriquement et éloignée du substrat après l'attaque du retrait de la couche (60, 160) d'électrode de commande,
on planarise la couche (62, 162) de mise à distance éloignée du substrat, on attaque en retrait sur toute la surface la couche (62, 162) de mise à distance éloignée du substrat.

2. Procédé suivant la revendication 1, **caractérisé en ce que**, lors de l'attaque en retrait de la couche (60, 160) d'électrode de commande planarisée, on met à nu une partie de la structure (12, 112) ou une partie d'une couche (58, 70, 163) isolante recouvrant la structure (12, 112).

3. Procédé suivant la revendication 1 ou 2, **caractérisé en ce que**, lors de l'attaque en retrait sur toute la surface de la couche (56, 156) de mise à distance proche du substrat, on met à nu une partie de la structure (12, 112).

4. Procédé suivant l'une des revendications précédentes, **caractérisé en ce que**, lors de l'attaque en retrait sur toute la surface de la couche (62, 162) de mise à distance éloignée du substrat, on met à nu une partie de la structure (12, 112) ou une partie d'une couche (58, 70, 163) isolante recouvrant la structure (12, 112).

5. Procédé suivant l'une des revendications précédentes, **caractérisé par** au moins l'un des stades :
après le dépôt de la couche (62, 162) de mise à distance éloignée du substrat, on dépose une couche (64, 164) d'électrode de borne, qui sert à la formation d'une électrode de borne du transistor (10, 100) à effet de champ,
on planarise la couche (64, 164) d'électrode de borne.

6. Procédé suivant la revendication 5, **caractérisé par** le stade, dans lequel :
on structure conjointement la couche (60, 160) d'électrode de commande et la couche (62, 162) de mise à distance éloignée du substrat et, de préférence aussi, la couche (56, 156) de mise à distance proche du substrat.

7. Procédé suivant l'une des revendications précédentes, **caractérisé par** le stade, dans lequel :
on forme une couche (58, 70, 163) isolante du point de vue électrique sur une partie de la structure (12, 112) après l'attaque en retrait de la couche (56, 156) de mise à distance proche du substrat et avant le dépôt de la couche (60, 160) d'électrode de commande.

8. Procédé suivant la revendication 7, **caractérisé en ce qu'**on produit la couche (58, 70, 163) isolante du point de vue électrique par un dépôt de couche sur toute la surface ou par une croissance thermique, notamment par une oxydation thermique.

9. Procédé suivant l'une des revendications précédentes, **caractérisé en ce qu'**on forme la structure (12, 112) à l'aide d'un masque (52, 152) dur, le masque (52, 152) dur étant utilisé, de préférence, dans au moins un stade de planarisation ou dans tous les stades mentionnés de planarisation, comme couche d'arrêt.

10. Procédé suivant l'une des revendications précédentes, **caractérisé par** au moins l'un des stades :
on dépose une couche (159) d'accumulation de charge après le dépôt de la couche (56, 156) de mise à distance proche du substrat et avant le dépôt de la couche (60, 160) d'électrode de commande,
on structure la couche (159) d'accumulation de charge avant le dépôt de la couche (60, 160) d'électrode de commande.

11. Procédé suivant la revendication 10, **caractérisé par** au moins l'un des stades :
on planarise la couche (159) d'accumulation de charge,
on attaque en retrait sur toute la surface la couche (159) d'accumulation de charge, une partie de la structure (112) ou
une partie d'une couche (158) isolante recouvrant la structure (112) étant, de préférence, mise à nu,
on forme au moins un élément (161) de mise à distance sur la structure (112),
on structure la couche (159) d'accumulation de charge en utilisant l'élément (161) de mise à distance.
